(19) Europäisches Patentamt
European Patent Office
Office européen des brevets

(11) **EP 3 584 823 A1**

(12) **EUROPEAN PATENT APPLICATION**
published in accordance with Art. 153(4) EPC

(43) Date of publication:
**25.12.2019 Bulletin 2019/52**

(21) Application number: **18754373.1**

(22) Date of filing: **06.02.2018**

(51) Int Cl.:
$H01L\ 21/304^{(2006.01)}$     $B24B\ 37/00^{(2012.01)}$
$C09K\ 3/14^{(2006.01)}$

(86) International application number:
**PCT/JP2018/003971**

(87) International publication number:
**WO 2018/150945 (23.08.2018 Gazette 2018/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(30) Priority: **20.02.2017 JP 2017029153**

(71) Applicant: **Fujimi Incorporated**
**Kiyosu-shi, Aichi 452-8502 (JP)**

(72) Inventors:
- **TSUCHIYA, Kohsuke**
 **Kiyosu-shi**
 **Aichi 452-8502 (JP)**
- **ASADA, Maki**
 **Kiyosu-shi**
 **Aichi 452-8502 (JP)**
- **MOMOTA, Satoshi**
 **Kiyosu-shi**
 **Aichi 452-8502 (JP)**

(74) Representative: **Grünecker Patent- und
Rechtsanwälte
PartG mbB
Leopoldstraße 4
80802 München (DE)**

(54) **SILICON SUBSTRATE INTERMEDIATE POLISHING COMPOSITION AND SILICON SUBSTRATE POLISHING COMPOSITION SET**

(57) Provided is a polishing composition which is used in a step upstream of a final polishing step of a silicon substrate and can effectively realize a high-quality surface after the final polishing step. According to the present invention, there is provided an intermediate polishing composition to be used in the intermediate polishing step in a silicon substrate polishing process including both of the intermediate polishing step and the final polishing step. The intermediate polishing composition includes an abrasive $A_1$, a basic compound $B_1$, and a surface protective agent $S_1$. The surface protective agent $S_1$ includes a water-soluble polymer $P_1$ having a weight average molecular weight of higher than $30 \times 10^4$ and a dispersant $D_1$, and has a dispersibility parameter $\alpha_1$ of less than 80%.

EP 3 584 823 A1

## Description

### Technical Field

The present invention relates to an intermediate polishing composition for a silicon substrate and a polishing composition set for a silicon substrate including the intermediate polishing composition. The present application claims priority based on Japanese Patent Application No. 2017-29153 filed on February 20, 2017, the entire contents of which application are incorporated herein by reference.

### Background Art

In general, the surface of a silicon substrate used for manufacturing a semiconductor product or the like is finished into a high-quality mirror surface through a lapping step and a polishing step. The polishing step is typically constituted by a plurality of polishing steps including both of a stock polishing step and a final polishing step. Patent Literature 1 to 3 exemplify technical literature related to polishing of semiconductor substrates such as silicon wafers.

Citation List

Patent Literature

    Patent Literature 1: Japanese Patent Application Publication No. 2012-89862
    Patent Literature 2: Japanese Patent Application Publication No. 2015-124231
    Patent Literature 3: Japanese Patent Application Publication No. 2016-4953

### Summary of Invention

Technical Problem

As semiconductor design rules are becoming finer, it is required to finish the silicon substrate to a surface of higher quality. For example, it is desirable to further reduce the number of micro particles generally referred to as LPD (Light Point Defect; LPD) on the surface after final polishing. Patent Literature 1 discloses a technique for improving the wettability of the surface after polishing and reducing micro defects such as adhesion of particles and the like by using a final polishing composition containing a water-soluble polymer compound having a low viscosity. Patent Literature 2 discloses a technique for similarly improving wettability after polishing and reducing surface defects by using hydroxyethyl cellulose which satisfies predetermined radius of gyration and contact angle. However, even with such techniques, it is sometimes impossible to cope sufficiently with the recent level of requirements relating to surface quality after final polishing.

Accordingly, an object of the present invention is to provide a polishing composition which is used in a step upstream of a final polishing step of a silicon substrate and can effectively realize a high-quality surface after the final polishing step. Another object of the present invention is to provide a polishing composition set for a silicon substrate including such a polishing composition.

Solution to Problem

According to this specification, there is provided an intermediate polishing composition to be used in an intermediate polishing step in a silicon substrate polishing process including both of the intermediate polishing step and the final polishing step. The intermediate polishing composition includes an abrasive $A_1$, a basic compound $B_1$, and a surface protective agent $S_1$. The surface protective agent $S_1$ includes a water-soluble polymer $P_1$ having a weight average molecular weight (Mw) of higher than $30 \times 10^4$ and further includes a dispersant $D_1$. A dispersibility parameter $\alpha_1$ of the surface protective agent $S_1$ is less than 80%. Since such an intermediate polishing composition includes the water-soluble polymer $P_1$ having a Mw of higher than $30 \times 10^4$, both the removal ability suitable for the intermediate polishing step and the protective ability for the surface of the polishing object can be suitably achieved. In addition, since the dispersibility parameter $\alpha_1$ of the surface protective agent $S_1$ is limited to less than 80%, the dispersibility of the water-soluble polymer $P_1$ in the intermediate polishing composition is satisfactory, and the occurrence of defects caused by the water-soluble polymer $P_1$ can be effectively prevented. Further, by using the dispersant $D_1$, the dispersibility of the water-soluble polymer $P_1$ can be improved and the value of the dispersibility parameter $\alpha_1$ can be further reduced. With such an intermediate polishing composition, it is possible to realize, in the intermediate polishing step, the surface of the polishing object on which a high-quality surface can be easily obtained after the final polishing step.

The content of the dispersant $D_1$ in the surface protective agent $S_1$ can be, for example, 0.8 times or less the content of the water-soluble polymer $P_1$. As a result, the removal ability and the surface protective ability suitable for the intermediate polishing step can be more suitably achieved compatible, and the surface of the polishing object on which a surface of higher quality can be easily obtained after the final polishing step can be realized.

A dispersant having a Mw of $3 \times 10^4$ or less can be preferably used as the dispersant $D_1$. Such a dispersant $D_1$ tends to reduce effectively the dispersibility parameter $\alpha_1$. Therefore, the removal ability and the surface protective ability suitable for the intermediate polishing step can be more suitably achieved compatible.

In a preferred embodiment of the art disclosed herein, the surface protective agent $S_1$ includes a cellulose derivative as the water-soluble polymer $P_1$. In such an embodiment, the effects of applying the present invention can be particularly suitably exhibited.

The content of the surface protective agent $S_1$ can be, for example, 0.005 g or more and 5 g or less per 100 g of the content of the abrasive $A_1$. As a result of setting the content of surface protective agent $S_1$ into this range, both the removal ability and the surface protective ability suitable for the intermediate polishing step are easy to be suitably realized.

In a preferred embodiment, the abrasive $A_1$ may include silica particles. In the embodiment in which the abrasive $A_1$ is composed of silica particles, the effects of applying the present invention can be particularly suitably exhibited.

According to this specification, there is also provided a polishing composition set for silicon substrates including any of the intermediate polishing compositions disclosed herein and a final polishing composition to be used in the final polishing step. The final polishing composition may include an abrasive $A_2$, a basic compound $B_2$, and a surface protective agent $S_2$. The surface protective agent $S_2$ typically includes a water-soluble polymer $P_2$. It is preferable that in the polishing composition set, the dispersibility parameter $\alpha_1$ of the surface protective agent $S_1$ contained in the intermediate polishing composition and the dispersibility parameter $\alpha_2$ of the surface protective agent $S_2$ contained in the final polishing composition satisfy the following equation: $(\alpha_1/\alpha_2) \geq 0.5$. By polishing a silicon substrate by using the polishing composition set having such a configuration, a silicon substrate having a high-quality surface can be suitably manufactured.

The dispersibility parameter $\alpha_2$ of the surface protective agent $S_2$ contained in the final polishing composition is preferably 1% or more and 30% or less. By using such a final polishing composition, a surface of higher quality of the polishing object can be realized.

**Description of Embodiments**

Preferred embodiments of the present invention will be described below. Incidentally, matters other than matters particularly mentioned in the present specification and necessary for the implementation of the present invention can be grasped as design matters of those skilled in the art based on the prior art in the relevant field. The present invention can be carried out based on the contents disclosed in this specification and technical common sense in the field.

In this specification, the "final polishing step" refers to a polishing step arranged at the end (that is, the most downstream side) of the polishing steps performed using polishing compositions including an abrasive. The polishing composition used in the final polishing step is referred to as a "final polishing composition". Therefore, the final polishing composition in the art disclosed herein can be grasped as a polishing composition of the type used the most downstream among a plurality of types of polishing compositions used in the process of polishing a silicon substrate.

In this specification, the "intermediate polishing step" refers to a polishing step arranged immediately before the final polishing step among the polishing steps performed using polishing compositions including an abrasive. That is, of the stock polishing steps performed prior to the final polishing step, the intermediate polishing step is the stock polishing step arranged most downstream. Further, the polishing composition used in the intermediate polishing step is referred to as an "intermediate polishing composition". Therefore, the intermediate polishing composition in the art disclosed herein is grasped as a polishing composition of the type used second from the downstream side among a plurality of types of polishing compositions used in the process of polishing a silicon substrate. The intermediate polishing step may be the first polishing step in the stock polishing step (the first sub-step of stock polishing), or may be the second or subsequent polishing sub-step. The intermediate polishing composition disclosed herein can be suitably used in an embodiment in which the intermediate polishing step is the second or subsequent polishing sub-step in the stock polishing step. That is, the intermediate polishing composition disclosed herein can be preferably used in the intermediate polishing step of a silicon substrate subjected to the first sub-step of stock polishing.

The art disclosed herein is preferably applied to polishing silicon substrates (in particular, silicon wafers) as polishing objects. A typical example of the silicon wafer referred to herein is a silicon single crystal wafer, for example, a silicon single crystal wafer obtained by slicing a silicon single crystal ingot. The surface to be polished in the art disclosed herein is typically a surface made of silicon. Prior to the intermediate polishing step disclosed herein, the silicon substrate may be subjected to general treatment that can be applied to the silicon substrate in a step upstream of the intermediate polishing step, such as lapping, etching, or the above-described the first sub-step of stock polishing, or the like.

In the following description, the term "polishing composition" is sometimes used as a term referring to a general polishing composition to be used in the polishing step, regardless of which polishing step uses the polishing composition (for example, whether it is an intermediate polishing composition or a final polishing composition).

<Surface Protective Agent $S_1$>

The intermediate polishing composition disclosed herein includes an abrasive $A_1$, a basic compound $B_1$, and a surface protective agent $S_1$. The surface protective agent $S_1$ includes a water-soluble polymer $P_1$ having a weight average molecular weight (Mw) of higher than $30 \times 10^4$, further includes a dispersant $D_1$, and has a dispersibility parameter $\alpha_1$ of less than 80%.

(Mw of Water-soluble Polymer $P_1$)

The water-soluble polymer $P_1$ functions to enhance the protection of the surface of the polishing object in the intermediate polishing step. As a result, the smoothness of the surface of the polishing object (here, a silicon substrate) when completed the intermediate polishing step can be further enhanced. A high smoothness when completed the intermediate polishing means that the roughness to be eliminated in the final polishing step is a small amount and the pressure on the final polishing step is small. Therefore, even where a final polishing composition having lower removal ability such as polishing removal ability is used in the final polishing step, the roughness presenting at the start of the final polishing can be reduced to a desired level. By using the final polishing composition with lower removal ability, the pressure applied to the polishing object in the final polishing step can be reduced to prevent the occurrence of defects, and the surface quality of the polishing object after the final polishing can be improved.

As the water-soluble polymer $P_1$, a polymer having a Mw of higher than $30 \times 10^4$ is used. The Mw of the water-soluble polymer $P_1$ ($Mw_{P1}$) is preferably higher than $40 \times 10^4$ and more preferably higher than $50 \times 10^4$. As the $Mw_{P1}$ increases, the number of molecules contained per weight of the water-soluble polymer $P_1$ decreases, so that the removal ability suitable for the intermediate polishing step can be easily obtained. From this viewpoint, a water-soluble polymer $P_1$ having a $Mw_{P1}$ of $70 \times 10^4$ or more can be preferably used. In one embodiment, $Mw_{P1}$ may be $85 \times 10^4$ or more, for example, $100 \times 10^4$ or more. The upper limit of $Mw_{P1}$ is not particularly limited, and may be, for example, $250 \times 10^4$ or less, or $200 \times 10^4$ or less. From the viewpoint of reducing the dispersibility parameter $\alpha_1$, in one embodiment, a water-soluble polymer $P_1$ having a $Mw_{P1}$ of $170 \times 10^4$ or less (for example, $150 \times 10^4$ or less) can be preferably used. $Mw_{P1}$ may be, for example, $130 \times 10^4$ or less.

The relationship between the weight average molecular weight (Mw) and the number average molecular weight (Mn) of the water-soluble polymer $P_1$ is not particularly limited. From the viewpoint of preventing the occurrence of aggregates and the like, for example, a molecular weight distribution (Mw/Mn) of 10.0 or less is preferable and 7.0 or less is more preferable. Further, Mw/Mn is 1.0 or more in principle, and is typically 1.05 or more. The art disclosed herein can also be suitably implemented in an embodiment in which the Mw/Mn of the water-soluble polymer $P_1$ is 2.0 or more (for example 3.0 or more, or 4.0 or more, or 5.0 or more).

In the present specification, as the weight average molecular weight (Mw) and number average molecular weight (Mn) of the water-soluble polymer and the dispersant described hereinbelow, values based on gel permeation chromatography (GPC) (aqueous system, in terms of polyethylene oxide) can be used.

(Dispersibility Parameter $\alpha_1$)

The dispersibility parameter $\alpha_1$ of the surface protective agent $S_1$ is calculated according to the following equation with a filtration time $T_0$ and $T_1$ of vacuum filtration which performed by a predetermined method; a filtration time $T_0$ of 100 g of a standard solution containing a standard polymer, ammonia, and water as the remaining amount; a filtration time $T_1$ of 100 g of a test solution containing the surface protective agent $S_1$, ammonia, and water as the remaining amount:

$$\text{Dispersibility parameter } \alpha_1 \ (\%) = (T_1/T_0) \times 100$$

Here, the concentration of the ammonia of each of the standard solution and the test solution is 0.57% by weight. As the standard polymer, hydroxyethyl cellulose (HEC) having a weight average molecular weight (Mw) of $120 \times 10^4$ is used. The concentration of the standard polymer in the standard solution is 0.12% by weight. The concentration of the surface protective agent $S_1$ in the test solution is adjusted so that the concentration of the water-soluble polymer

$P_1$ constituting the surface protective agent $S_1$ is the same as the concentration of the standard polymer (that is, 0.12% by weight).

The filtration times $T_0$ and $T_1$ are measured as follows.

[Vacuum Filtration Conditions]

Filter used:

Type: membrane filter ($\phi$ 47 mm, disc type)
Material: mixed cellulose ester
Pore diameter: 1.0 $\mu$m
Vacuum pressure: 0.005 MPa

[Procedure for Measuring filtration Time]

A membrane filter is attached to a vacuum filtration device, 100 g of deionized water is filtered in vacuo with the vacuum pressure indicated above, and then 100 g of the standard solution is filtered in vacuo. At this time, the time (filtration time) $T_0$ required for the filtration of 100 g of the standard solution is measured.

Then, the membrane filter is replaced with a new one, and 100 g of deionized water is filtered in vacuo at the above vacuum pressure, and then 100 g of the test solution is filtered in vacuo. At this time, the time (filtration time) $T_1$ required for the filtration of 100 g of the test solution is measured.

$\alpha_1$ thus determined can serve as a useful index for estimating an extent of dispersibility of the water-soluble polymer $P_1$ in the intermediate polishing composition. With the surface protective agent $S_1$ having $\alpha_1$ of less than 80%, the water-soluble polymer $P_1$ contained in the surface protective agent $S_1$ can be appropriately dispersed in the intermediate polishing composition, and the adverse effects which can be caused by including the water-soluble polymer $P_1$ in the intermediate polishing composition can be effectively prevented (for example, the occurrence of defects caused by the high-Mw water-soluble polymer $P_1$ and the like). With the surface protective agent $S_1$ having $\alpha_1$ of 75% or less (more preferably 70% or less, for example, 65% or less), higher effects can be exhibited. The art disclosed herein can also be suitably implemented in an embodiment in which $\alpha_1$ is 60% or less. The lower limit of $\alpha_1$ is not particularly limited, and may be, for example, 10% or more. From the viewpoint of enhancing the protective performance by the water-soluble polymer $P_1$, and the like, the appropriate $\alpha_1$ is usually 25% or more, and may be 40% or more, 45% or more, and 50% or more (for example, 55% or more). $\alpha_1$ can be adjusted by the selection of the type and molecular weight of the water-soluble polymer $P_1$, the selection and the amount used of the dispersant $D_1$, and the like.

Although there is no particular limitation, more preferable results can be realized by setting Mw of the water-soluble polymer $P_1$ higher against $\alpha_1$ within the range where the above-described condition of $\alpha_1$ is satisfied. From this viewpoint, the surface protective agent $S_1$ in the art disclosed herein can be configured, for example, such that $\alpha_1/Mw_{P_1}$ is $7.0 \times 10^{-7}$ or less. Here, $Mw_{P_1}$ is the Mw of the water-soluble polymer $P_1$, and is typically $30 \times 10^4$ or more. $\alpha_1$ is the dispersibility parameter of the surface protective agent $S_1$ and is typically less than 80% (that is, less than 0.8). It can be said that the surface protective agent $S_1$ having a small value of $\alpha_1/Mw_{P_1}$ has good dispersibility of the surface protective agent $S_1$ considering $Mw_{P_1}$ of the water-soluble polymer $P_1$. Therefore, with the intermediate polishing composition including the surface protective agent $S_1$ having a smaller $\alpha_1/Mw_{P_1}$, both the removal ability and the protective ability with the surface of the polishing object tend to be realized more suitably while the occurrence of defects caused by the use of the water-soluble polymer $P_1$ is being prevented. From this viewpoint, $\alpha_1/Mw_{P_1}$ is preferably $6.5 \times 10^{-7}$ or less, and more preferably $6.0 \times 10^{-7}$ or less. In one embodiment, $\alpha_1/Mw_{P_1}$ may be $5.5 \times 10^{-7}$ or less, for example, $5.0 \times 10^{-7}$ or less. The lower limit of $\alpha_1/Mw_{P_1}$ is not particularly limited. From the viewpoint of practicality, $\alpha_1/Mw_{P_1}$ may be, for example, $1.5 \times 10^{-7}$ or more, $2.0 \times 10^{-7}$ or more, $2.5 \times 10^{-7}$ or more, and $3.0 \times 10^{-7}$ or more (for example, $3.5 \times 10^{-7}$ or more). The art disclosed herein can also be suitably implemented in an embodiment in which $\alpha_1/Mw_{P_1}$ is $4.0 \times 10^{-7}$ or more (for example, $4.5 \times 10^{-7}$ or more).

(Water-soluble Polymer $P_1$)

In the art disclosed herein, the type of the water-soluble polymer $P_1$ is not particularly limited, and can be appropriately selected from water-soluble polymers known in the field of polishing compositions. The water-soluble polymer $P_1$ can be used singly or in combination of two or more types thereof.

For example, the water-soluble polymer $P_1$ can be selected from water-soluble polymers having at least one functional group selected from a cationic group, an anionic group and a nonionic group in the molecule. The water-soluble polymer may have, for example, a hydroxyl group, a carboxy group, an acyloxy group, a sulfo group, a primary amide structure, a heterocyclic structure, a vinyl structure, a polyoxyalkylene structure or the like in the molecule. A nonionic polymer can be preferably used as the water-soluble polymer $P_1$ from the viewpoint of reducing aggregates, improving the cleaning performance and the like.

The water-soluble polymer that can be used as the water-soluble polymer $P_1$ can be exemplified by a cellulose derivative, a starch derivative, a polymer including an oxyalkylene unit, a vinyl alcohol polymer, a polymer including a nitrogen atom, and the like. Among them, a cellulose derivative and a starch derivative are preferable, and a cellulose derivative is more preferable.

The cellulose derivative is a polymer including a β-glucose unit as the main repeating unit. Specific examples of the cellulose derivative include hydroxyethyl cellulose (HEC), hydroxypropyl cellulose, hydroxyethyl methyl cellulose, hydroxypropyl methyl cellulose, methyl cellulose, ethyl cellulose, ethyl hydroxyethyl cellulose, carboxymethyl cellulose and the like. Among these, HEC is preferred.

The starch derivative is a polymer including an α-glucose unit as the main repeat unit. Specific examples of the starch derivative include pregelatinized starch, pullulan, carboxymethyl starch, cyclodextrin and the like. Among them, pullulan is preferred.

Examples of the polymer including an oxyalkylene unit include polyethylene oxide (PEO), a block copolymer of ethylene oxide (EO) and propylene oxide (PO) or butylene oxide (BO), a random copolymer of EO and PO or BO and the like. Among them, a block copolymer of EO and PO or a random copolymer of EO and PO is preferable. The block copolymer of EO and PO may be a diblock copolymer, a triblock copolymer, and the like including PEO blocks and polypropylene oxide (PPO) blocks. Examples of the triblock copolymer include a PEO-PPO-PEO triblock copolymer and a PPO-PEO-PPO triblock copolymer. Usually, a PEO-PPO-PEO triblock copolymer is more preferable.

In the present specification, the term "copolymer" is meant to be inclusive of various types of copolymers such as random copolymers, alternating copolymers, block copolymers, graft copolymers, and the like, unless otherwise specified.

From the viewpoint of solubility in water, cleanability, and the like, in a block copolymer or random copolymer of EO and PO, the molar ratio (EO/PO) of EO to PO constituting the copolymer is preferably more than 1, more preferably 2 or more, and even more preferably 3 or more (for example, 5 or more).

The vinyl alcohol-based polymer is typically a polymer (PVA) including a vinyl alcohol unit (VA units) as the main repeating unit. In the polymer, the ratio of the number of moles of VA units to the number of moles of all repeating units is usually 50% or more, preferably 65% or more, and more preferably 70% or more, for example 75% or more. All repeating units may consist substantially of VA units. When the vinyl alcohol-based polymer includes both of a VA units and a non-VA units (that is, a repeating unit other than the VA unit), the type of the non-VA unit is not particularly limited. The non-VA unit is, for example, a structural unit derived from vinyl pyrrolidone, a structural unit derived from ethylene, an alkyl vinyl ether unit, a monocarboxylic acid vinyl ester unit, a structural unit obtained by acetalizing polyvinyl alcohol with aldehyde, and the like. Among them, a non-VA unit selected from the group consisting of a vinyl ether unit having an alkyl group having 1 or more and 10 or less carbon atoms(alkyl vinyl ether unit), a vinyl ester unit derived from a monocarboxylic acid having 1 or more and 7 or less carbon atoms (monocarboxylic acid vinyl ester unit), and a structural unit obtained by acetalized polyvinyl alcohol with aldehyde having an alkyl group having 1 or more and 7 or less carbon atoms are preferred.

Examples of the vinyl ether unit having an alkyl group having 1 or more and 10 or less carbon atoms include a methyl vinyl ether unit, n- and i-propyl vinyl ether units, n-, i- and t-butyl vinyl ether units, a 2-ethylhexyl vinyl ether unit and the like. Examples of the vinyl ester unit derived from a monocarboxylic acid having 1 or more and 7 or less carbon atoms include a vinyl propanoate unit, a vinyl butanoate unit, a vinyl pentanoate unit, a vinyl hexanoate unit and the like. Examples of the aldehyde having an alkyl group having 1 or more and 7 or less carbon atoms include acetaldehyde, n-butyraldehyde and the like.

A polymer including both of a VA unit and a non-VA units may include only one type of non-VA unit or two or more types of non-VA units as the non-VA unit. The content ratio (molar ratio) of the VA unit to the non-VA unit is not particularly limited. The VA unit: non-VA unit (molar ratio) may be, for example, 1 : 99 to 99 : 1, preferably 95 : 5 to 50 : 50, and more preferably 95 : 5 to 80 : 20.

The polymer including both of a VA unit and a non-VA unit can be exemplified by a copolymer including a vinyl alcohol unit and a vinyl pyrrolidone unit, a copolymer including a vinyl alcohol unit and an ethylene unit, a copolymer including a vinyl alcohol unit and a methyl vinyl ether unit, a copolymer including a vinyl alcohol unit and an n-propyl vinyl ether unit, a copolymer including a vinyl alcohol unit and an i-propyl vinyl ether unit, a copolymer including a vinyl alcohol unit and an n-butyl vinyl ether unit, a copolymer including a vinyl alcohol unit and an i-butyl vinyl ether unit, a copolymer including a vinyl alcohol unit and a t-butyl vinyl ether unit, a copolymer including a vinyl alcohol unit and a 2-ethylhexyl vinyl ether unit, a polymer obtained by acetalizing a part of polyvinyl alcohol with n-butyraldehyde, and the like.

The polymer including both of the VA unit and the non-VA unit may be a modified polyvinyl alcohol having a hydrophilic functional group in the side chain thereof. Examples of the hydrophilic functional group include an oxyalkylene group, a carboxy group, a sulfo group, an amino group, a hydroxyl group, an amide group, an imide group, a nitrile group, an ether group, an ester group, and salts thereof. For example, a cationized polyvinyl alcohol which has a cationic group, such as a quaternary ammonium structure, may be used as the modified polyvinyl alcohol. Examples of the cationized polyvinyl alcohol include those derived from a monomer having a cationic group such as diallyldialkylammonium salt and N-(meth)acryloylaminoalkyl-N,N,N-trialkylammonium salt.

The degree of saponification of PVA is usually 50 mol% or more, preferably 65 mol% or more, more preferably 70 mol% or more, for example 75 mol% or more. In addition, the saponification degree of PVA is, in principle, 100 mol% or less.

Non-limiting examples of the polymer including a nitrogen atom include a polymer including a monomer unit of an N-vinyl type; an imine derivative; a polymer including a monomer unit of an N-(meth)acryloyl type; and the like.

Examples of the polymer including a monomer unit of an N-vinyl type include polymers including a repeating unit derived from a monomer having a nitrogen-containing heterocycle (for example, a lactam ring). Examples of such polymer include homopolymers and copolymers of N-vinyl lactam type monomers (for example, a copolymer having a copolymerization ratio of the N-vinyl lactam type monomer of more than 50% by weight), homopolymers and copolymers of N-vinyl chain amides (for example, a copolymer having a copolymerization ratio of the N-vinyl chain amide of more than 50% by weight), and the like.

Specific examples of the N-vinyl lactam type monomer (that is, a compound having a lactam structure and an N-vinyl group in one molecule) include N-vinyl pyrrolidone (VP), N-vinyl piperidone, N-vinyl morpholinone, N-vinyl caprolactam (VC), N-vinyl-1,3-oxazin-2-one, N-vinyl-3,5-morpholinedione and the like. Specific examples of the polymer including a monomer unit of the N-vinyl lactam type include polyvinyl pyrrolidone, polyvinyl caprolactam, a random copolymer of VP and VC, a random copolymer of one or both of VP and VC with another vinyl monomer (for example, an acrylic monomer, a vinyl ester monomer and the like), a block copolymer or a graft copolymer including a polymer chain including one or both of VP and VC, and the like.

Specific examples of the N-vinyl chain amide include N-vinyl acetamide, N-vinyl propionic acid amide, N-vinyl butyric acid amide and the like.

Examples of the polymer including a monomer unit of an N-(meth)acryloyl type include a homopolymer and a copolymer of an N-(meth)acryloyl type monomer (typically, a copolymer having a copolymerization ratio of the N-(meth)acryloyl type monomer of more than 50% by weight). Examples of the N-(meth)acryloyl type monomer include a chain amide having an N-(meth)acryloyl group and a cyclic amide having an N-(meth)acryloyl group.

Examples of the chain amide having an N-(meth)acryloyl group include: (meth)acrylamide; an N-alkyl (meth)acrylamide such as N-methyl (meth)acrylamide, N-ethyl (meth)acrylamide, N-propyl (meth)acrylamide, N-isopropyl (meth)acrylamide, N-n-butyl (meth)acrylamide and the like; an N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, N,N-di(n-butyl) (meth)acrylamide and the like; and the like. Examples of the polymer including a chain amide including an N-(meth)acryloyl group as a monomer unit include a homopolymer of N-isopropylacrylamide and a copolymer of N-isopropylacrylamide (for example, a copolymer having a copolymerization ratio of N-isopropylacrylamide of more than 50% by weight).

Examples of the cyclic amide having an N-(meth)acryloyl group include N-(meth)acryloylmorpholine, N-(meth)acryloylpyrrolidine and the like. Examples of the polymer including a cyclic amide having an N-(meth)acryloyl group as a monomer unit include a homopolymer of N-acryloylmorpholine and a copolymer of N-acryloylmorpholine (for example, a copolymer having a copolymerization ratio of N-acryloylmorpholine of more than 50% by weight).

The art disclosed herein can be preferably implemented in an embodiment in which the surface protective agent $S_1$ includes at least a cellulose derivative (for example, HEC) as the water-soluble polymer $P_1$. For example, the art can be suitably implemented in an embodiment in which a cellulose derivative is used independently as the water-soluble polymer $P_1$. The art disclosed herein may also be implemented in an embodiment in which the water-soluble polymer $P_1$ includes a combination of a cellulose derivative and another water-soluble polymer. In such an embodiment, the proportion of the cellulose derivative (for example, HEC) in the entire water-soluble polymer $P_1$ can be, for example, 30% by weight or more (more preferably 50% by weight or more, and still more preferably 80% by weight or more).

(Dispersant $D_1$)

The surface protective agent $S_1$ in the intermediate polishing composition disclosed herein includes a combination of the water-soluble polymer $P_1$ and the dispersant $D_1$. By the use of the dispersant $D_1$, the dispersibility of the water-soluble polymer $P_1$ can be enhanced, and the dispersibility parameter $\alpha_1$ of the surface protective agent $S_1$ can be reduced. As a result, the types of materials that can be selected as the water-soluble polymer $P_1$ and the range of Mw can be expanded. For example, it is possible to use the water-soluble polymer $P_1$ having a higher Mw while preventing the increase in $\alpha_1$. The dispersant $D_1$ may also have the ability to protect the surface of the substrate.

A material capable of functioning as a dispersant (typically a water-soluble organic compound) for the water-soluble polymer $P_1$, that is, a material capable of reducing $\alpha_1$ of the surface protective agent $S_1$ when included in the surface protective agent $S_1$, can be used, as appropriate, as the dispersant $D_1$. The dispersants can be used singly or in combination of two or more types thereof.

As the dispersant $D_1$, for example, a surfactant can be used. Any of an anionic surfactant, a nonionic surfactant, a cationic surfactant and an amphoteric surfactant can be used. Usually, anionic or nonionic surfactants can be preferably used. From the viewpoint of low foaming property and easiness of pH adjustment, a nonionic surfactant is more preferable. Examples of the nonionic surfactant include oxyalkylene polymers such as polyethylene glycol, polypropylene glycol, polytetramethylene glycol and the like; polyoxyalkylene derivatives (for example, polyoxyalkylene adducts) such as polyoxyethylene alkyl ethers, polyoxyethylene alkyl phenyl ethers, polyoxyethylene alkylamines, polyoxyethylene fatty acid esters, polyoxyethylene glyceryl ether fatty acid esters, polyoxyethylene sorbitan fatty acid esters and the like; copolymers of plural types of oxyalkylenes (for example, diblock copolymers, triblock copolymers, random copolymers, and alternating copolymers), and the like. In one embodiment, a surfactant including a polyoxyalkylene structure (for example, a polyoxyethylene structure, a polyoxypropylene structure, and the like) in a molecule may be preferably used. The surfactant can be used singly or in combination of two or more types.

Specific examples of the nonionic surfactant include block copolymers of ethylene oxide (EO) and propylene oxide (PO) (a diblock copolymer, a PEO (polyethylene oxide) - PPO (polypropylene oxide) - PEO triblock, a PPO-PEO-PPO triblock copolymer and the like), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrenated phenyl ether, polyoxyethylene lauryl amine, polyoxyethylene stearyl amine, polyoxyethylene oleyl amine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, polyoxyethylene hydrogenated castor oil, and the like. Among them, examples of preferred surfactants include a block copolymer of EO and PO (in particular, a PEO-PPO-PEO triblock copolymer) and a polyoxyethylene alkyl ether (for example, polyoxyethylene decyl ether).

The Mw of the dispersant $D_1$ is not particularly limited, and is usually suitably $10 \times 10^4$ or less (for example, $5 \times 10^4$ or less). From the viewpoint of more efficiently improving the dispersibility of the water-soluble polymer $P_1$, the Mw of the dispersant $D_1$ may be $3 \times 10^4$ or less, $2 \times 10^4$ or less, or $1 \times 10^4$ or less, and 9500 or less (for example, 9000 or less). From the viewpoint of making the dispersibility improvement function easier to exhibit, usually, the Mw of the dispersant $D_1$ is suitably 200 or more, and preferably 250 or more (for example, 300 or more). A more preferable range of Mw of the dispersant $D_1$ may vary depending on the type of the dispersant $D_1$. For example, when a polyoxyethylene alkyl ether is used as the dispersant $D_1$, the Mw thereof is preferably 2000 or less, and may be 1000 or less (for example, 500 or less). In addition, for example, when a PEO-PPO-PEO triblock copolymer is used as the dispersant $D_1$, the Mw thereof may be, for example, 1000 or more, 3000 or more, or 5000 or more. The same applies to the dispersant $D_2$ described hereinbelow.

(Content of Surface Protective Agent $S_1$)

The concentration of the surface protective agent $S_1$ in the intermediate polishing composition is not particularly limited, and can be, for example, 0.0001% by weight or more. From the viewpoint of obtaining a higher protective effect, the preferred concentration is 0.0005% by weight or more, and more preferably 0.001% by weight or more. Further, the concentration of the surface protective agent $S_1$ can be, for example, 0.5% by weight or less. From the viewpoint of obtaining processing ability suitable for the intermediate polishing step, usually, the concentration is suitably 0.1% by weight or less, and preferably 0.05% by weight or less. From the viewpoint of obtaining higher processing ability, the concentration may be 0.01% by weight or less (for example, 0.005% by weight or less). The art disclosed herein can also be suitably implemented, for example, in an embodiment in which the concentration of the surface protective agent $S_1$ in the intermediate polishing composition is less than 0.005% by weight.

Although not particularly limited, the content of the surface protective agent $S_1$ with respect to 100 g of the content of the abrasive $A_1$ can be, for example, 0.001 g or more, and usually suitably 0.005 g or more. From the viewpoint of obtaining a higher protective effect, the content may be 0.01 g or more, 0.05 g or more, 0.1 g or more, 0.5 g or more, or 1 g or more (for example, 1.2 g or more). Further, from the viewpoint of obtaining removal ability suitable for the intermediate polishing step, usually, the content of the surface protective agent $S_1$ with respect to 100 g of the content of the abrasive $A_1$ is suitably 10 g or less, and preferably 7 g or less. From the viewpoint of obtaining higher processing ability, the content may be 5 g or less and 3 g or less. The art disclosed herein can also be suitably implemented in an embodiment in which the content of the surface protective agent $S_1$ is 2.5 g or less (for example, 2.0 g or less) with respect to 100 g of the content of the abrasive $A_1$.

The concentration of the water-soluble polymer $P_1$ in the intermediate polishing composition is not particularly limited, and can be, for example, 0.0001% by weight or more. From the viewpoint of obtaining a higher protective effect, the preferred concentration is 0.0005% by weight or more, and more preferably 0.001% by weight or more. Further, the concentration of the water-soluble polymer $P_1$ can be, for example, less than 0.5% by weight. From the viewpoint of obtaining removal ability suitable for the intermediate polishing step, usually, the concentration is suitably less than 0.1% by weight, and preferably less than 0.05% by weight. From the viewpoint of obtaining higher removal ability, the concentration may be less than 0.01% by weight (for example, less than 0.005% by weight). The art disclosed herein can also be suitably implemented, for example, in an embodiment in which the concentration of the water-soluble polymer $P_1$ in the intermediate polishing composition is less than 0.005% by weight.

Although not particularly limited, the content of the water-soluble polymer $P_1$ can be, for example, 0.001 g or more with respect to 100 g of the content of the abrasive $A_1$ and usually suitably 0.01 g or more. From the viewpoint of obtaining a higher protective effect, the content may be 0.05 g or more, 0.1 g or more, 0.5 g or more, or 1.0 g or more (for example, 1.2 g or more). Further, from the viewpoint of obtaining removal ability suitable for the intermediate polishing step, the content of the water-soluble polymer $P_1$ with respect to 100 g of the content of the abrasive $A_1$ is usually suitably less than 10 g, and preferably less than 7 g. From the viewpoint of obtaining higher removal ability, the content may be less than 5 g or less than 3 g. The art disclosed herein can also be suitably implemented in an embodiment in which the content of the water-soluble polymer $P_1$ is less than 2.5 g (for example, less than 2.0 g) with respect to 100 g of the content of the abrasive $A_1$.

The content of the dispersant $D_1$ (for example, a surfactant) in the intermediate polishing composition is not particularly limited, and can be set so as to obtain a desired effect. From the viewpoint of facilitating exertion of the removal ability suitable for the intermediate polishing step, the content of the dispersant $D_1$ in the intermediate polishing composition is usually suitably smaller than the content of the water-soluble polymer $P_1$. The content of the dispersant $D_1$ can be, for example, 0.8 times or less, and from the viewpoint of placing more importance on removal ability, 0.5 times or less, or 0.3 times or less the content of the water-soluble polymer $P_1$. Further, the content (by weight) of the dispersant $D_1$ can be, for example, 0.001 times or more, usually suitably 0.01 times or more, and from the viewpoint of obtaining a higher effect, 0.03 times or more, or 0.05 times or more (for example, 0.1 times or more) the content of the water-soluble polymer $P_1$.

In the art disclosed herein, the type and amount used of the dispersant $D_1$ can be set so that the effect of reducing the dispersibility parameter $\alpha_1$ as a result of using the dispersant $D_1$ can be appropriately exhibited. Although not particularly limited, in one embodiment, the type and amount used of the dispersant $D_1$ can be set so that the dispersibility parameter $\alpha_1$ of the surface protective agent $S_1$ including the dispersant $D_1$ is lower, for example, by 5% or more (preferably 10% or more, and more preferably 20% or more) than a dispersibility parameter $\alpha_{1B}$ of a surface protective agent $S_{1B}$ which is a composition obtained by removing the dispersant $D_1$ from the surface protective agent $S_1$. Here, the dispersibility parameter $\alpha_{1B}$ of the surface protective agent $S_{1B}$ can be obtained by using the surface protective agent $S_{1B}$ instead of the surface protective agent $S_1$ in the above-described measurement of the dispersibility parameter $\alpha_1$. The surface protective agent $S_1$ in the art disclosed herein can be configured such that $\alpha_1$ is lower than $\alpha_{1B}$ by 25% or more (for example, 30% or more, 35% or more, or 40% or more).

The dispersibility parameter $\alpha_{1B}$ of the surface protective agent $S_{1B}$ (that is, the surface protective agent of the composition obtained by removing the dispersant $D_1$ from the surface protective agent $S_1$) may be, for example, 80% or more, 85% or more, 90% or more, or 95% or more. As $\alpha_{1B}$ becomes larger, the effect of protecting the surface of the polishing object and the polishing removal rate tend to be improved. The upper limit of $\alpha_{1B}$ is not particularly limited. From the viewpoint of easily obtaining the removal ability suitable for the intermediate polishing, in one embodiment, $\alpha_{1B}$ may be 200% or less, or may be 150% or less (for example, 120% or less).

The surface protective agent $S_1$ in the art disclosed herein may further include a water-soluble polymer $P_L$ having a Mw of $30 \times 10^4$ or less as a component different from the dispersant $D_1$. The water-soluble polymer $P_L$ is, for example, any kind of the water-soluble polymers exemplified above, and the Mw thereof may be $30 \times 10^4$ or less (for example, $20 \times 10^4$ or less, or $15 \times 10^4$ or less, or $10 \times 10^4$ or less, or $5 \times 10^4$ or less). The lower limit of Mw of the water-soluble polymer $P_L$ is not particularly limited, and may be, for example, $1 \times 10^4$ or more. The amount used of the water-soluble polymer $P_L$ is usually suitably less than 1.0 times, preferably 0.5 times or less, and may be 0.1 times or less or 0.05 times or less the amount used of the water-soluble polymer $P_1$ on the weight basis. The art disclosed herein can also be suitably implemented in an embodiment in which the surface protective agent $S_1$ is substantially free of the water-soluble polymer $P_L$.

<Abrasive $A_1$>

The material and properties of the abrasive to be used as the abrasive $A_1$ are not particularly limited and can be appropriately selected according to the purpose of use and application. Examples of the abrasive include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, red iron oxide particles and the like; nitride particles such as silicon nitride particles, boron nitride particles and the like; carbide particles such as silicon carbide particles, boron carbide particles and the like; diamond particles; and carbonates such as calcium carbonate, barium carbonate and the like. Specific examples of the organic particles include polymethyl methacrylate (PMMA) particles, poly(meth)acrylic acid particles (herein, (meth)acrylic acid means to be inclusive of acrylic acid and methacrylic acid), polyacrylonitrile particles and the like. Such abrasives may be used singly or in combination of two or more types thereof.

As the above abrasive, inorganic particles are preferable, and among them, particles composed of oxides of metals or metalloids are preferable, and silica particles are particularly preferable. The art disclosed herein can be preferably implemented, for example, in an embodiment in which the abrasive $A_1$ is substantially composed of silica particles. Here, "substantially" means that 95% by weight or more (preferably 98% by weight or more, more preferably 99% by weight or more, and may be 100% by weight) of the particles constituting the abrasive are silica particles.

Specific examples of silica particles include colloidal silica, fumed silica, precipitated silica and the like. The silica particles may be used singly or in combination of two or more types. The use of colloidal silica is particularly preferable, since a polished surface excellent in surface quality can be easily obtained after polishing. For example, colloidal silica prepared by an ion exchange method using water glass (sodium silicate) as a raw material and alkoxide method colloidal silica (colloidal silica produced by a hydrolytic condensation reaction of an alkoxysilane) can be preferably used. Colloidal silica may be used singly or in combination of two or more types.

The true specific gravity of the material constituting the abrasive (for example, silica constituting silica particles) is preferably 1.5 or more, more preferably 1.6 or more, and even more preferably 1.7 or more. As a result of increasing the true specific gravity of the material constituting the abrasive, the physical polishing ability tends to increase. From this viewpoint, the abrasive having a true specific gravity of 2.0 or more (for example, 2.1 or more) is particularly preferable. The upper limit of the true specific gravity of the abrasive is not particularly limited and is typically 2.3 or less, for example, 2.2 or less. A measured value obtained by a liquid displacement method using ethanol as a displacement liquid can be used as the true specific gravity of the abrasive (for example, silica particles).

The BET diameter of the abrasive $A_1$ (typically, silica particles) is not particularly limited. From the viewpoint of polishing removal rate and the like, the BET diameter is preferably 5 nm or more, more preferably 10 nm or more, and particularly preferably 20 nm or more. From the viewpoint of obtaining a higher polishing effect (for example, from the viewpoint of reducing surface roughness Ra, cancelling bumps and the like), the abrasive $A_1$ having the BET diameter of 25 nm or more, more preferably 30 nm or more (for example, 32 nm or more) can be preferably used. Further, from the viewpoint of reducing scratching and the like, the BET diameter of the abrasive $A_1$ is preferably 100 nm or less, more preferably 70 nm or less, and further preferably 60 nm or less. In one embodiment, the BET diameter of the abrasive $A_1$ may be 50 nm or less (for example, 40 nm or less).

In the present specification, the BET diameter refers to the particle diameter calculated by a formula of BET diameter (nm) = 6000/(true density (g/cm$^3$) $\times$ BET value (m$^2$/g)) from the specific surface area (BET value) measured by the BET method. For example, in the case of silica particles, the BET diameter can be calculated from BET diameter (nm) = 2727/BET value (m$^2$/g). The specific surface area can be measured, for example, by using a surface area measuring apparatus "Flow Sorb II 2300" manufactured by Micromeritics Instrument Corporation.

The shape (outer shape) of the abrasive may be globular or non-globular. Specific examples of non-globular particles include particles of a peanut shape (that is, the shape of a peanut shell), a cocoon shape, a konpeito shape, a rugby ball shape, and the like. For example, an abrasive in which most of the particles have a peanut shape or a cocoon shape can be preferably used.

Although not particularly limited, the average value of the major axis/minor axis ratio (average aspect ratio) of the abrasive is in principle 1.0 or more, preferably 1.05 or more, and even more preferably 1.1 or more. By increasing the average aspect ratio, it is possible to achieve higher polishing removal rate. From the viewpoint of reducing scratching and the like, the average aspect ratio of the abrasive is preferably 3.0 or less, more preferably 2.0 or less, and even more preferably 1.5 or less.

In this specification, the shape (outer shape) and the average aspect ratio of the abrasive can be grasped by, for example, observation with an electron microscope. A specific procedure for grasping the average aspect ratio includes, for example, drawing a minimum rectangle circumscribing each particle image for a predetermined number (for example, 200 particles) of silica particles for which the shape of an independent particle can be recognized by using a scanning electron microscope (SEM). Then, with respect to the rectangle drawn for each particle image, a value obtained by dividing the length of the longer side (a value of a major axis) by the length of the shorter side (a value of the minor axis) is calculated as the value of the major axis/the value of the minor axis ratio (the aspect ratio). By arithmetically averaging the aspect ratios of the predetermined number of particles, the average aspect ratio can be obtained.

The content of the abrasive $A_1$ in the intermediate polishing composition is not particularly limited. In one embodiment, the content is preferably 0.001% by weight or more, more preferably 0.01% by weight or more, and still more preferably 0.1% by weight or more (for example, 0.2% by weight or more). By increasing the content of the abrasive $A_1$, it is possible to realize higher polishing removal rate. Further, from the viewpoint of removability from the polishing object, and the like, the content of the abrasive $A_1$ is usually suitably 10% by weight or less, preferably 5% by weight or less, more preferably 1% by weight or less, and even more preferably 0.8% by weight or less (for example, 0.5% by weight or less).

<Water>

The intermediate polishing composition disclosed herein typically contains water. As the water, ion exchange water (deionized water), pure water, ultrapure water, distilled water or the like can be preferably used. In order to minimize the inhibition of the action of other components contained in the intermediate polishing composition, it is preferable that the total content of transition metal ions in the water used be, for example, 100 ppb or less. For example, the purity of water can be increased by operations such as removal of impurity ions with ion exchange resin, removal of contaminants with a filter, by distillation and the like.

<Basic Compound $B_1$>

The basic compound $B_1$ can be appropriately selected from various basic compounds having a function of dissolving in water to raise the pH of the aqueous solution. For example, an organic or inorganic basic compound including nitrogen, a hydroxide of an alkali metal, a hydroxide of an alkaline earth metal, various carbonates, bicarbonates and the like can be used. Examples of nitrogen-containing basic compounds include quaternary ammonium compounds, quaternary phosphonium compounds, ammonia, amines (preferably, water-soluble amines) and the like. Such basic compounds may be used singly or in combination of two or more types thereof.

Specific examples of the alkali metal hydroxide include potassium hydroxide, sodium hydroxide and the like. Specific examples of the carbonate and bicarbonate include ammonium hydrogen carbonate, ammonium carbonate, potassium hydrogen carbonate, potassium carbonate, sodium hydrogen carbonate, sodium carbonate and the like. Specific examples of the amine include methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, azoles such as imidazole and triazole and the like. Specific examples of the quaternary phosphonium compound include a quaternary phosphonium hydroxide such as tetramethylphosphonium hydroxide, tetraethylphosphonium hydroxide and the like.

A quaternary ammonium salt (typically, a strong base) such as a tetraalkylammonium salt, a hydroxyalkyltrialkylammonium salt or the like can be preferably used as the quaternary ammonium compound. The anion component in such a quaternary ammonium salt can be, for example, $OH^-$, $F^-$, $Cl^-$, $Br^-$, $I^-$, $ClO_4^-$, $BH_4^-$ and the like. Among them, a quaternary ammonium salt with $OH^-$ as an anion, that is, a quaternary ammonium hydroxide can be mentioned as a preferable example. Specific examples of the quaternary ammonium hydroxide include a tetraalkylammonium hydroxide such as tetramethylammonium hydroxide, tetraethylammonium hydroxide, tetrapropylammonium hydroxide, tetrabutylammonium hydroxide, tetrapentylammonium hydroxide, tetrahexylammonium hydroxide and the like; a hydroxyalkyltrialkylammonium hydroxide such as 2-hydroxyethyltrimethylammonium hydroxide (also referred to as choline) and the like; and the like. Among these, tetraalkylammonium hydroxides are preferable, and among them, tetramethylammonium hydroxide (TMAH) is particularly preferable.

In the art disclosed herein, at least one basic compound selected from an alkali metal hydroxide, a quaternary ammonium hydroxide and ammonia is preferred as the basic compound $B_1$ contained in the intermediate polishing composition. Among these, quaternary ammonium hydroxide and ammonia are more preferable, and ammonia is particularly preferable. The intermediate polishing composition disclosed herein is preferably implemented, for example, in an embodiment including a surface protective agent $S_1$ including at least a cellulose derivative (for example, HEC) as the water-soluble polymer $P_1$, and a basic compound $B_1$ including ammonia.

<Other Components>

The intermediate polishing composition disclosed herein may optionally include a well-known additive that can be used in polishing compositions (typically, polishing compositions to be used in a step of polishing silicon substrates), such as a chelating agent, an organic acid, an organic acid salt, an inorganic acid, an inorganic acid salt, an antiseptic agent, an antifungal agent and the like, as long as the effects of the present invention are not significantly impaired.

Examples of the chelating agent include an aminocarboxylic acid-based chelating agent and an organophosphonic acid-based chelating agent. Examples of the aminocarboxylic acid-based chelating agent include ethylenediaminetetraacetic acid, sodium ethylenediaminetetraacetate, nitrilotriacetic acid, sodium nitrilotriacetate, ammonium nitrilotriacetate, hydroxyethylethylenediaminetriacetic acid, sodium hydroxyethylethylenediaminetriacetate, diethylenetriaminepentaacetic acid, sodium diethylenetriaminepentaacetate, triethylenetetraminehexaacetic acid, and sodium triethylenetetraminehexaacetate. Examples of the organophosphonic acid-based chelating agent include 2-aminoethyl phosphonic acid, 1-hydroxyethylidene-1,1-diphosphonic acid, aminotri(methylene phosphonic acid), ethylenediaminetetrakis(methylene phosphonic acid), diethylenetriaminepenta(methylene phosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methane hydroxyphosphonic acid, 2-phosphonobutane-1,2-dicarboxylic acid, 1-phosphonobutane-2,3,4-tricarboxylic acid and $\alpha$-methylphosphonosuccinic acid. Among these, organophosphonic acid-based chelating agents are more preferable. Among them, ethylenediaminetetrakis(methylene phosphonic acid), diethylenetriaminepenta(methylene phosphonic acid) and diethylenetriaminepentaacetic acid are preferable. Ethylenediaminetetrakis(methylene phosphonic acid) and diethylenetriaminepenta(methylene phosphonic acid) are particularly preferable as the chelating agent. The chelating agents can be used singly or in combination of two or more types. The intermediate polishing composition in the art disclosed herein may be an embodiment substantially free of a chelating agent.

Examples of the organic acid include a fatty acid such as formic acid, acetic acid, propionic acid and the like, aromatic carboxylic acids such as benzoic acid, phthalic acid and the like, citric acid, oxalic acid, tartaric acid, malic acid, maleic acid, fumaric acid, succinic acid, an organosulfonic acid, an organophosphonic acid and the like. Examples of the organic acid salt include an alkali metal salt (a sodium salt, a potassium salt and the like) and an ammonium salt of an organic acid. Examples of the inorganic acid include sulfuric acid, nitric acid, hydrochloric acid, carbonic acid and the like.

Examples of the inorganic acid salt include an alkali metal salt (a sodium salt, a potassium salt and the like) and an ammonium salt of an inorganic acid. Organic acids and salts thereof and inorganic acids and salts thereof can be used singly or in combination of two or more types thereof.

Examples of the antiseptic agent and antifungal agent include isothiazoline compounds, p-hydroxybenzoates, phenoxyethanol and the like.

It is preferable that the intermediate polishing composition is substantially free of an oxidant. Where an oxidant is included in the intermediate polishing composition, while the intermediate polishing composition is supplied to the polishing object (here, a silicon substrate), an oxide layer generates by oxidizing the surface of the polishing object. This may cause to be lowered the polishing removal rate. Specific examples of the oxidant referred to herein include hydrogen peroxide ($H_2O_2$), sodium persulfate, ammonium persulfate, sodium dichloroisocyanurate and the like. In addition, the intermediate polishing composition being substantially free of an oxidant means that an oxidant is not included at least intentionally.

<pH>

The pH of the intermediate polishing composition is usually suitably 8.0 or more, preferably 8.5 or more, more preferably 9.0 or more, and still more preferably 9.5 or more, for example 10.0 or more. When the pH of the intermediate polishing composition is increased, the removal ability tends to be improved. Meanwhile, from the viewpoint of preventing the dissolution of the abrasive (for example, silica particles) and suppressing weakening of mechanical polishing effect by the abrasive, the pH of the intermediate polishing composition is suitably 12.0 or less, preferably 11.8 or less, more preferably 11.5 or less, and still more preferably 11.0 or less.

In the art disclosed herein, the pH of the composition can be grasped by performing three-point calibration using a standard buffer solution (a phthalate pH buffer solution, pH: 4.01 (at 25°C), a neutral phosphate pH buffer solution, pH: 6.86 (at 25°C), and a carbonate pH buffer solution, pH: 10.01 (at 25°C)) by using a pH meter (for example, a glass electrode type hydrogen ion concentration indicator manufactured by Horiba Ltd. (model number F-23)), then placing a glass electrode in the composition to be measured, and measuring a pH value after the composition has been stabilized for 2 min or longer.

<Final Polishing Composition>

The polishing object that has been subjected to the intermediate polishing step using such an intermediate polishing composition is further subjected to a final polishing step. A final polishing composition to be used in the final step is not particularly limited. In one embodiment, a final polishing composition including abrasive $A_2$, a basic compound $B_2$ and a surface protective agent $S_2$ may be preferably used.

(Abrasive $A_2$)

Although the abrasive $A_2$ contained in the final polishing composition is not particularly limited, usually, silica particles can be preferably used similarly to the abrasive $A_1$ of the intermediate polishing composition. As the silica particles, colloidal silica is particularly preferable. For example, colloidal silica produced using an alkoxysilane as a raw material can be preferably used. Colloidal silica can be used singly or in combination of two or more types. The preferable true specific gravity of the abrasive used as the abrasive $A_2$, the outer shape and average aspect ratio of the abrasives are the same as those of the abrasive $A_1$ of the intermediate polishing composition, and the redundant description thereof is herein omitted.

The BET diameter of the abrasive $A_2$ (typically, silica particles) is not particularly limited. From the viewpoint of polishing removal rate and the like, the BET diameter is preferably 5 nm or more, and more preferably 10 nm or more. From the viewpoint of obtaining a higher polishing effect (for example, effects such as reducing haze, removing defects and the like), the BET diameter of the abrasive $A_2$ is preferably 15 nm or more, and more preferably 20 nm or more (for example, more than 20 nm). In addition, from the viewpoint of easily obtaining a surface having a higher smoothness, the BET diameter of the abrasive $A_2$ is preferably 100 nm or less, more preferably 50 nm or less, and further preferably 40 nm or less. From the viewpoint of making it easier to obtain a higher quality surface and the like, in one embodiment, an abrasive $A_2$ having a BET diameter of 35 nm or less (typically less than 35 nm, preferably less than 32 nm, for example less than 30 nm) may be used.

The content of the abrasive $A_2$ in the final polishing composition is not particularly limited. In one embodiment, the content may be, for example, 0.01% by weight or more, 0.03% by weight or more, or 0.05% by weight or more (for example, 0.08% by weight or more). By increasing the content of the abrasive $A_2$, a higher polishing effect can be realized. From the viewpoint of removability from the polishing object and the like, the content of the abrasive $A_2$ is usually suitably 7% by weight or less, preferably 5% by weight or less, more preferably 3% by weight or less, and even more preferably 2% by weight or less (for example, 1% by weight or less). In one embodiment, the content of the abrasive $A_2$ may be 0.5% by weight or less, 0.3% by weight or less, or 0.2% by weight or less.

(Basic Compound $B_2$)

As the basic compound $B_2$ contained in the final polishing composition, for example, one or two or more types of basic compounds exemplified as the basic compound $B_1$ which can be used for the intermediate polishing composition can be selected and used. As the basic compound $B_2$, for example, at least one basic compound selected from alkali metal hydroxides, quaternary ammonium hydroxides and ammonia can be preferably used. Among these, quaternary ammonium hydroxide and ammonia are more preferable, and ammonia is particularly preferable.

(Surface Protective Agent $S_2$)

The surface protective agent $S_2$ of the final polishing composition preferably includes at least a water-soluble polymer $P_2$. As the water-soluble polymer $P_2$, for example, those similar to the water-soluble polymers exemplified as the water-soluble polymer $P_1$ that can be used for the surface protective agent $S_1$ of the intermediate polishing composition can be used. The water-soluble polymers $P_2$ can be used singly or in combination of two or more types.

A cellulose derivative (for example, HEC) can be mentioned as a suitable example of the water-soluble polymer which may be used as the water-soluble polymer $P_2$. Cellulose derivatives may be used singly or in combination with other water-soluble polymers. For example, an embodiment in which the water-soluble polymer $P_2$ includes a combination of a cellulose derivative and another water-soluble polymer is preferable. In such an embodiment, the proportion of the cellulose derivative (for example, HEC) in the entire water-soluble polymer $P_2$ can be, for example, 10% by weight or more, 25% by weight or more, 40% by weight or more, 60% by weight or more, 75% by weight or more, or 90% by weight or more.

Another preferable example of the water-soluble polymer which can be used as the water-soluble polymer $P_2$ is a polymer including a nitrogen atom. The polymer including a nitrogen atom may be used singly or in combination with other water-soluble polymers (for example, cellulose derivatives). Non-limiting examples of the polymer including a nitrogen atom include a polymer including an N-vinyl type monomer unit such as N-vinyl lactam, N-vinyl chain amide and the like; an imine derivative; a polymer including an N-(meth)acryloyl monomer unit; and the like.

Examples of the polymer including a nitrogen atom that includes an N-vinyl type monomer unit include polymers including a repeating unit derived from a monomer having a nitrogen-containing heterocycle (for example, a lactam ring). Examples of such a nitrogen atom-containing polymer include homopolymers and copolymers of N-vinyl lactam type monomers (for example, a copolymer having a copolymerization ratio of the N-vinyl lactam type monomer of more than 50% by weight), homopolymers and copolymers of N-vinyl chain amide (for example, a copolymer having a copolymerization ratio of the N-vinyl chain amide of more than 50% by weight), and the like.

Specific examples of the N-vinyl lactam type monomer include N-vinyl pyrrolidone (VP), N-vinyl piperidone, N-vinyl morpholinone, N-vinyl caprolactam (VC), N-vinyl-1,3-oxazine-2-one, N-vinyl-3,5-morpholindione and the like. Specific examples of the polymer including an N-vinyl lactam type monomer unit include polyvinyl pyrrolidone, polyvinyl caprolactam, a random copolymer of VP and VC, a random copolymer of one or both of VP and VC with another vinyl monomer (for example, an acrylic monomer, a vinyl ester monomer and the like), and a block copolymer or a graft copolymer including a polymer chain including one or both of VP and VC and the like.

Specific examples of the N-vinyl chain amide include N-vinyl acetamide, N-vinyl propionic acid amide, N-vinyl butyric acid amide and the like.

Examples of the polymer including an N-(meth)acryloyl type monomer unit include a homopolymer and a copolymer of an N-(meth)acryloyl type monomer (typically, a copolymer having a copolymerization ratio of the N-(meth)acryloyl type monomer of more than 50% by weight). Examples of the N-(meth)acryloyl type monomer include a chain amide having an N-(meth)acryloyl group and a cyclic amide having an N-(meth)acryloyl group.

Examples of the chain amide having an N-(meth)acryloyl group include: (meth)acrylamide; an N-alkyl (meth)acrylamide such as N-methyl (meth)acrylamide, N-ethyl (meth)acrylamide, N-propyl (meth)acrylamide, N-isopropyl (meth)acrylamide, N-n-butyl (meth)acrylamide and the like; an N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, N,N-di(n-butyl) (meth)acrylamide and the like; and the like. Examples of the polymer including a chain amide having an N-(meth)acryloyl group as a monomer unit include a homopolymer of N-isopropylacrylamide and a copolymer of N-isopropylacrylamide (for example, a copolymer having a copolymerization ratio of N-isopropylacrylamide of more than 50% by weight).

Examples of the cyclic amide having an N-(meth)acryloyl group include N-(meth)acryloylmorpholine, N-(meth)acryloylpyrrolidine and the like. Examples of the polymer including a cyclic amide having an N-(meth)acryloyl group as a monomer unit include a homopolymer of N-acryloylmorpholine and a copolymer of N-acryloylmorpholine (for example, a copolymer having a copolymerization ratio of N-acryloylmorpholine of more than 50% by weight).

In an embodiment including a combination of a cellulose derivative and a polymer including a nitrogen atom as the water-soluble polymer $P_2$, for example, a polymer including an N-vinyl polymer chain can be preferably used as the polymer including a nitrogen atom. Here, the polymer chain is a concept inclusive of a polymer chain constituting an entire polymer of one molecule and a polymer chain constituting a part of a polymer of one molecule. Further, the N-vinyl polymer chain refers to a polymer chain in which the copolymerization ratio of the N-vinyl type monomer is more than 50% by weight and equal to or less than 100% by weight. For example, a water-soluble polymer composed of a polymer chain (N-vinyl lactam type polymer chain) in which the content of a repeating unit derived from an N-vinyl lactam type monomer such as N-vinyl pyrrolidone, N-vinyl piperidone, N-vinyl caprolactam and the like is more than 50% by weight and equal to or less than 100% by weight, and a copolymer (a graft copolymer, a block copolymer and the like) in which a part of a polymer of one molecule is composed of an N-vinyl lactam type polymer chain can be preferably used as the water-soluble polymer $P_2$. A graft copolymer of polyvinyl alcohol and polyvinyl pyrrolidone can be mentioned as an example of the copolymer in which a part of the polymer of one molecule is constituted by the N-vinyl lactam type polymer chain.

A polymer including such an N-vinyl polymer chain can be preferably used as one component of the water-soluble polymer $P_2$ in combination with a cellulose derivative, and in another embodiment, such a polymer may be used in combination with a water-soluble polymer (for example, a vinyl alcohol-based polymer, a polymer including an oxyalkylene unit and the like) other than a cellulose derivative. The water-soluble polymer $P_2$ may also be a composition including only a polymer including an N-vinyl polymer chain, a composition including only a vinyl alcohol-based polymer, a composition including only a polymer including an oxyalkylene unit, a composition including a combination of a vinyl alcohol-based polymer and a cellulose derivative, a composition including a composition of a polymer including an oxyalkylene unit and a cellulose derivative, and the like.

The Mw of the water-soluble polymer $P_2$ is not particularly limited. The Mw of the water-soluble polymer $P_2$ may be, for example, $200 \times 10^4$ or less, $150 \times 10^4$ or less, $100 \times 10^4$ or less, or $70 \times 10^4$ or less. From the viewpoint of filtration ability and cleanability, in one embodiment, a water-soluble polymer $P_2$ having a Mw of less than $50 \times 10^4$ (more preferably less than $30 \times 10^4$, for example $28 \times 10^4$ or less) can be preferably used. The Mw of the water-soluble polymer $P_2$ is usually preferably $1 \times 10^4$ or more (for example, $2 \times 10^4$ or more).

In one embodiment of the art disclosed herein, the weight average molecular weight $Mw_{P1}$ of the water-soluble polymer $P_1$ contained in the intermediate polishing composition and the weight average molecular weight $Mw_{P2}$ of the water-soluble polymer $P_2$ contained in the final polishing composition are preferably selected such as to satisfy the relationship of $Mw_{P1} > Mw_{P2}$. As the result, a surface of higher quality is likely to be realized after final polishing. The water-soluble polymer $P_1$ and the water-soluble polymer $P_2$ can be selected, for example, such that $Mw_{P1}/Mw_{P2}$ to be 1.3 or more. In one embodiment, $Mw_{P1}/Mw_{P2}$ may be 1.5 or more, 2 or more, 3 or more, or 4 or more. Further, $Mw_{P1}/Mw_{P2}$ can be, for example, 100 or less, 50 or less, 20 or less, and in one embodiment, 10 or less (for example, 7.0 or less).

When one or both of the water-soluble polymer $P_1$ and the water-soluble polymer $P_2$ are composed of two or more water-soluble polymers different in Mw from each other, the $Mw_{P1}$ and $Mw_{P2}$ are compared with respect to the water-soluble polymers with the highest Mw contained in each water-soluble polymer.

The surface protective agent $S_2$ contained in the final polishing composition is preferably such that the dispers-

ibility parameter $\alpha_2$ of the surface protective agent $S_2$ satisfy the relationship of $\alpha_1/\alpha_2 \geq 0.5$ with the dispersibility parameter $\alpha_1$ of the surface protective agent $S_1$ described above. Here, the dispersibility parameter $\alpha_2$ of the surface protective agent $S_2$ can be obtained by using the surface protective agent $S_2$ instead of the surface protective agent $S_1$ in the measurement of the above-described dispersibility parameter $\alpha1$. By performing the intermediate polishing step and the final polishing step using the intermediate polishing composition and the final polishing composition selected such that $\alpha_1/\alpha_2$ is 0.5 or more, the surface smoothness of the polishing object can be effectively improved while preventing the occurrence of defects. Therefore, a surface of higher quality can be efficiently realized after final polishing. With the intermediate polishing composition and the final polishing composition selected such that $\alpha_1/\alpha_2$ is 1.0 or more, more preferably 1.5 or more, for example 3.5 or more or 5.0 or more, more favorable results can be realized. The upper limit of $\alpha_1/\alpha_2$ is not particularly limited, and in practical use, $\alpha_1/\alpha_2$ is usually appropriately set to 10 or less, preferably 8 or less, for example, 6 or less.

The dispersibility parameter $\alpha_2$ of the surface protective agent $S_2$ can be, for example, 50% or less, and is usually preferably 30% or less, and more preferably 20% or less. The reduction of $\alpha_2$ tends to improve the filtration ability and cleanability. From the viewpoint of improving the surface protection of the polishing object and the wettability after polishing, the dispersibility parameter $\alpha_2$ is usually suitably 1% or more, and preferably 5% or more.

The surface protective agent $S_2$ may include a dispersant $D_2$ in addition to the water-soluble polymer $P_2$. By using the dispersant $D_2$, the dispersibility parameter $\alpha_2$ of the surface protective agent $S_2$ can be adjusted, and the above-mentioned preferable $\alpha_1/\alpha_2$ can be easily satisfied. From the viewpoint of improving the filtration ability and the cleanability of the final polishing composition, it is also preferable to reduce the dispersibility parameter $\alpha_2$. As the dispersant $D_2$, one or two or more can be selected and used from the materials exemplified as the dispersant $D_1$ which can be used for the surface protective agent $S_1$ of the intermediate polishing composition. In one embodiment, a surfactant (preferably, a nonionic surfactant) having a Mw of $1 \times 10^4$ or less can be used as the dispersant $D_2$. Examples of preferred surfactants include a block copolymer of EO and PO (in particular, a PEO-PPO-PEO triblock copolymer) and a polyoxyethylene alkyl ether (for example, polyoxyethylene decyl ether).

The concentration of the surface protective agent $S_2$ in the final polishing composition is not particularly limited, and can be, for example, 0.0005% by weight or more. From the viewpoint of obtaining a higher protective effect, the preferred concentration is 0.001% by weight or more, and more preferably 0.002% by weight or more. In one embodiment, the concentration of the surface protective agent $S_2$ may be 0.003% by weight or more, or 0.005% by weight or more. Further, the concentration of the surface protective agent S2 may be, for example, 1.0% by weight or less, and is usually suitably 0.5% by weight or less, and may be 0.1% by weight or less, and 0.05% by weight or less (for example, 0.02% by weight or less).

Although not particularly limited, the content of the surface protective agent $S_2$ with respect to 100 g of the content of the abrasive $A_2$ can be, for example, 0.01 g or more, and is usually suitably 0.05 g or more. From the viewpoint of obtaining a higher protective effect, the content may be 0.1 g or more, 0.5 g or more, 1 g or more, or 2 g or more (for example, 3 g or more). Further, from the viewpoint of filtration ability and cleanability, the content of the surface protective agent $S_2$ with respect to 100 g of the content of the abrasive $A_2$ is usually suitably 15 g or less, and may be 10 g or less, and 7 g or less (for example, 5 g or less).

The content $C_{P2}$ of the water-soluble polymer $P_2$ per 100 g of the content of the abrasive $A_2$ in the final polishing composition can be set such that the relationship with $C_{P1}$ becomes, for example, such that $C_{P2}/C_{P1}$ is 1.0 or more (typically, greater than 1.0), wherein the $C_{P1}$ is the content of the water-soluble polymer $P_1$ per 100 g of the content of the abrasive $A_1$ in the intermediate polishing composition. The art disclosed herein may be suitably implemented in an embodiment in which $C_{P2}/C_{P1}$ is 1.2 or more (for example, 1.5 or more, or 2.0 or more, or 2.5 or more). Further, $C_{P2}/C_{P1}$ may be, for example, 10 or less, and is usually suitably 7 or less, and may be 5 or less. By performing the intermediate polishing step and the final polishing step by using the intermediate polishing composition and the final polishing composition satisfying such a relationship of $C_{P2}/C_{P1}$, the surface smoothness of the polishing object can be effectively improved while preventing the occurrence of defects.


(Water)


The final polishing composition typically includes water. As the water, the same water as that for the intermediate polishing composition can be used.


(Other Components)


Similar to the intermediate polishing composition, the final polishing composition may optionally include a well-known additive that can be used in polishing compositions (typically, polishing compositions to be used in a step of polishing silicon substrates), such as a chelating agent, an organic acid, an organic acid salt, an inorganic acid, an inorganic acid salt, an antiseptic agent, an antifungal agent and the like, as long as the effects of the present invention are not significantly impaired. The final polishing composition in the art disclosed herein may be an embodiment substantially free of a chelating agent. Further, it is preferable that, similarly to the intermediate polishing composition, the final polishing composition be substantially free of an oxidant.

The pH of the final polishing composition is usually suitably 8.0 or more, preferably 8.5 or more, more preferably 9.0 or more, still more preferably 9.5 or more, and particularly preferably 9.8 or more. When the pH of the final polishing composition is increased, the removal ability tends to be improved. Meanwhile, from the viewpoint of preventing the dissolution of the abrasive (for example, silica particles) and preventing weakening of mechanical polishing effect by the abrasive, the pH of the intermediate polishing composition is suitably 12.0 or less, preferably 11.8 or less, more preferably 11.5 or less, and still more preferably 11.0 or less (for example, 10.5 or less).

<Polishing>

Typically, the polishing composition disclosed herein is used for polishing a polishing object, for example, in the below-described manner in the form of a polishing slurry including the polishing composition. Thus, a polishing slurry to be used in each polishing step or at each sub-step of polishing is prepared. Then, the polishing slurry (working slurry) is supplied to the polishing object and polishing is performed by a conventional method. For example, the polishing object is set in a polishing machine, and the polishing slurry is supplied to the surface (surface to be polished) of the polishing object through a polishing pad fixed to a platen (polishing platen) of the polishing machine. Typically, the polishing pad is pressed against the surface of the polishing object and the two are moved relative to each other (for example, rotational movement) while the polishing slurry is continuously supplied.

Each polishing slurry may be in a concentrated form (that is, in the form of a concentrate of the polishing slurry and may be grasped as a stock solution of the polishing slurry) before being supplied to the polishing object. That is, the concept of a polishing composition in the art disclosed herein is inclusive of both a polishing slurry (working slurry) that is supplied to a polishing object and used for polishing the polishing object, and a concentrate (that is, a stock solution of polishing slurry) that is diluted and used as a polishing slurry after dilution. The polishing slurry (concentrate) in such a concentrated form is advantageous from the viewpoints of convenience, cost reduction, and the like at the time of production, distribution, storage, and the like. The concentration factor is not particularly limited, and can be, for example, about 2 times to 100 times in terms of volume, and usually suitably about 5 times to 50 times (for example, about 10 times to 40 times) in terms of volume.

The content of the abrasive in the concentrate can be, for example, 50% by weight or less. From the viewpoint of handleability (for example, dispersion stability of abrasive and filterability) of the concentrate and the like, usually, the content of the abrasive in the concentrate is preferably 45% by weight or less, and more preferably 40% by weight or less. Further, from the viewpoint of convenience and cost reduction and the like in production, distribution, storage and the like, the content of the abrasive can be, for example, 0.5% by weight or more, preferably 1% by weight or more, and more preferably 3% by weight or more (for example, 4% by weight or more). In a preferred embodiment, the content of the abrasive may be 5% by weight or more, or 10% by weight or more (for example, 15% by weight or more, or 20% by weight or more, or 30% by weight or more).

Such a concentrate can be diluted at a desired timing to prepare a polishing slurry (working slurry) and used in the form of supplying the polishing slurry to a polishing object. The dilution can be performed, for example, by adding water to the concentrate and mixing.

The polishing composition disclosed herein may be of a one-agent type or a multi-agent type such as a two-agent type. For example, the polishing slurry may be configured to be prepared by mixing Part A including at least the abrasive among the constituent components of the polishing slurry and Part B including the remaining components, and diluting as necessary at appropriate timing.

A method for preparing the polishing composition is not particularly limited. For example, the respective components contained in the polishing composition may be mixed using a known mixing device such as a blade type stirrer, an ultrasonic disperser, a homomixer or the like. The mode of mixing these components is not specifically limited. For example, all the components may be mixed at once, or may be mixed in a suitably set order.

As a polishing machine, a double-side polishing machine that simultaneously polishes each surface of a polishing object may be used, or a single-side polishing machine may be used to polish only one surface of the polishing object. In the intermediate polishing step and the final polishing step, a single-side polishing machine can be preferably used. The polishing pad used in each polishing step is not particularly limited. For example, polishing pads of a foamed polyurethane type, a nonwoven fabric type, a suede type or the like can be used. Each polishing pad may or may not include an abrasive.

According to the polishing method disclosed herein, polishing of a polishing object (here, a silicon substrate, typically a silicon single crystal wafer) is completed through the above-described intermediate polishing step and final polishing step. Therefore, as another aspect of the art disclosed herein, there is provided a method for producing a polished object (resultant product obtained by polishing) including polishing a polishing object by using a polishing process including an intermediate polishing step performed using any of the intermediate polishing compositions disclosed herein and a final polishing step (typically, a final polishing step performed using any of the final polishing compositions disclosed herein) performed after the intermediate polishing step.

< Polishing Composition Set>

According to this specification, a polishing composition set is provided that can be preferably used in a silicon substrate polishing process including both of an intermediate polishing step and a final polishing step. The polishing composition set includes at least any intermediate polishing composition and final polishing composition disclosed herein. The intermediate polishing composition may be a polishing slurry or a concentrate thereof to be used in the intermediate polishing step. Similarly, the final polishing composition may be a polishing slurry or a concentrate thereof to be used in the final polishing step. A composition including an abrasive $A_2$, a basic compound $B_2$ and a surface protective agent $S_2$, in which the surface protective agent $S_2$ includes a water-soluble polymer $P_2$ and $(\alpha_1/\alpha_2) \geq 0.5$ is satisfied can be preferably used as the final polishing composition. By performing the intermediate polishing step and the final polishing step by using the intermediate polishing composition and the final polishing composition contained in such a polishing composition set, a silicon substrate having a high-quality surface can be effectively manufactured.

Examples

Several examples relating to the present invention will be described below, but the present invention is not intended to be limited to these examples. In the following description, "%" is on a weight basis except when representing the numerical value of the dispersibility parameter.

<Intermediate Polishing Composition>

(Example 1)

An intermediate polishing composition was prepared including, in ion exchange water, 0.23% of colloidal silica having a BET diameter of 35 nm as the abrasive $A_1$, 0.003% of hydroxyethyl cellulose (HEC) having a Mw of $120 \times 10^4$ as the water-soluble polymer $P_1$, 0.0004% of a PEO-PPO-PEO block copolymer having a Mw of 9000 as the dispersant $D_1$, 0.01% of ammonia as the basic compound $B_1$, and the balance being water.

(Examples 2 and 3)

Intermediate polishing compositions according to Examples 2 and 3 were prepared in the same manner as in Example 1 except that the concentration of the dispersant $D_1$ was changed as shown in Table 1.

(Example 4)

An intermediate polishing composition according to the present example was prepared in the same manner as in Example 3 except that HEC having a Mw of $50 \times 10^4$ was used as the water-soluble polymer $P_1$.

(Example 5)

An intermediate polishing composition according to the present example was prepared in the same manner as in Example 4 except that polyoxyethylene decyl ether (C10PEO5) having the number of added moles of ethylene oxide of 5 was used as the dispersant $D_1$ at a concentration of 0.00002%.

(Comparative Example 1)

An intermediate polishing composition according to Comparative Example 1 was prepared in the same manner as in Example 1 except that the dispersant $D_1$ was not used.

(Comparative Example 2)

An intermediate polishing composition according to Comparative Example 2 was prepared in the same manner as in Example 4 except that the dispersant $D_1$ was not used.

(Comparative Example 3)

An intermediate polishing composition according to Comparative Example 3 was prepared in the same manner as in Comparative Example 2 except that the concentration of the water-soluble polymer $P_1$ was changed to 0.006%.

(Comparative Example 4)

An intermediate polishing composition according to the present example was prepared in the same manner as in Example 4 except that HEC having a Mw of $25 \times 10^4$ was used as the water-soluble polymer $P_1$.

(Comparative Example 5)

An intermediate polishing composition according to the present example was prepared in the same manner as in Example 1 except that the concentration of the dispersant $D_1$ was changed to 0.00001%.

For each of the intermediate polishing compositions according to these Examples and Comparative Examples, the dispersibility parameter $\alpha_1$ of the surface protective agent $S_1$ was measured by the method described above. The results are shown in Table 1.

<Polishing of Silicon Wafer>

(1) Stock Polishing Step

A stock polishing composition including 0.95% of an abrasive and 0.0645% of a basic compound, with the balance being water, was prepared. Colloidal silica having a BET diameter of 35 nm was used as the abrasive. Potassium hydroxide (KOH) was used as a basic compound. Using this stock polishing composition as it was as a polishing slurry (working slurry), a silicon wafer as a polishing object was polished under the following polishing conditions 1. As a silicon wafer, a commercially available silicon single crystal wafer (conductivity type: P type, crystal orientation: <100>, resistivity: 1 $\Omega$·cm or more and less than 100 $\Omega$·cm, COP free) having a diameter of 300 mm after lapping and etching was used.

[Polishing Conditions 1]

Polishing machine: Single wafer polishing machine manufactured by Okamoto Machine Tool Works, Ltd., model "PNX-332B"
Polishing pressure: 20 kPa
Platen rotational speed: 20 rpm
Carrier rotational speed: 20 rpm
Polishing pad: manufactured by Fujibo Ehime Co., Ltd., product name "FP55"
Flow rate of polishing slurry: 1 L/min
Temperature of polishing slurry: 20°C
Temperature of platen cooling water: 20°C
Polishing time: 2 min

(2) Intermediate Polishing Step

Each of the intermediate polishing compositions according to the Examples and Comparative Examples described above was used as it was as a polishing slurry (working slurry), and the silicon wafer after the stock polishing step was polished under the following polishing conditions 2.

[Polishing Conditions 2]

Polishing machine: Single wafer polishing machine manufactured by Okamoto Machine Tool Works, Ltd., model "PNX-332B"
Polishing pressure: 15 kPa
Platen rotational speed: 30 rpm
Carrier rotational speed: 30 rpm
Polishing pad: polishing pad manufactured by Fujibo Ehime Co., Ltd., product name "POLYPAS 27NX"
Flow rate of polishing slurry: 2 L/min
Temperature of polishing slurry: 20°C

Temperature of platen cooling water: 20°C
Polishing time: 2 min

(3) Final Polishing Step

A final polishing composition was prepared which included 0.18% of colloidal silica having a BET diameter of 25 nm, 0.004% of HEC having a Mw of $25 \times 10^4$ and 0.003% of polyvinyl pyrrolidone having a Mw of $4.5 \times 10^4$ as the water-soluble polymers $P_2$, 0.0002% of polyoxyethylene decyl ether (C10PEO5) having the number of added moles of ethylene oxide of 5 as the dispersant $D_2$, and 0.005% of ammonia as the basic compound $B_1$, the balance being water, in ion exchange water. The final polishing composition was used as it was as a polishing slurry (working slurry), and the silicon wafer after the intermediate polishing step was polished under the polishing conditions 2. In addition, the dispersibility parameter $\alpha_2$ of the surface protective agent $S_2$ contained in the final polishing composition was measured by the above-described method. The result was 13%.

The polished silicon wafer was removed from the polishing machine and cleaned (SC-1 Cleaning) using a cleaning solution of $NH_4OH$ (29%) : $H_2O_2$ (31%) : deionized water (DIW) = 1 : 3 : 30 (volume ratio). More specifically, two cleaning tanks equipped with an ultrasonic oscillator with a frequency of 950 kHz were prepared, the cleaning solution was accommodated in each of the first and second cleaning tanks, and held at 60°C, the polished silicon wafer was immersed in the first cleaning tank for 6 min, then rinsed in a tank with ultrapure water under ultrasonic vibrations, and immersed in the second cleaning tank for 6 min while the above ultrasonic oscillator was operated. The wafer was then pulled up to an isopropyl alcohol (IPA) atmosphere and made to dry.

In this way, a silicon wafer polished by the polishing process including a stock polishing step using a common stock polishing composition, an intermediate polishing step using each of the intermediate polishing compositions according to Examples and Comparative Examples, and a final polishing step using a common final polishing composition was obtained.

<Evaluation of Number of LPD >

The number of defects (particles) having a size of 37 nm or more present on the surface of a silicon wafer obtained in each Example and Comparative Example was counted using a wafer defect tester ("Surfscan SP2" (trade name) manufactured by KLA-Tencor Corporation). The counted number of defects (the number of LPDs) was converted into a relative value with the number of LPDs of Comparative Example 1 being taken as 100, and is shown in Table 1.

[Table 1]

Table 1

| | Surface protective agent $S_1$ | | | | | $\alpha_1$ [%] | Relative value of LPD |
| | Water-soluble polymer $P_1$ | | | Dispersant $D_1$ | | | |
| | Type | $Mw_{P1}$ [x $10^4$] | Concentration [wt%] | Type | Concentration [wt%] | | |
|---|---|---|---|---|---|---|---|
| Example 1 | HEC | 120 | 0.003 | PEO-PPO-PEO | 0.0004 | 59 | 36 |
| Example 2 | HEC | 120 | 0.003 | PEO-PPO-PEO | 0.0003 | 64 | 46 |
| Example 3 | HEC | 120 | 0.003 | PEO-PPO-PEO | 0.0001 | 74 | 62 |
| Example 4 | HEC | 50 | 0.003 | PEO-PPO-PEO | 0.0001 | 28 | 60 |
| Example 5 | HEC | 50 | 0.003 | C10PEO5 | 0.00002 | 30 | 65 |
| Comparative Example 1 | HEC | 120 | 0.003 | - | - | 100 | 100 |

(continued)

| | Surface protective agent $S_1$ | | | | | $\alpha_1$ [%] | Relative value of LPD |
|---|---|---|---|---|---|---|---|
| | Water-soluble polymer $P_1$ | | | Dispersant $D_1$ | | | |
| | Type | $Mw_{P_1}$ [x $10^4$] | Concentration [wt%] | Type | Concentration [wt%] | | |
| Comparative Example 2 | HEC | 50 | 0.003 | - | - | 33 | 76 |
| Comparative Example 3 | HEC | 50 | 0.006 | - | - | 33 | 79 |
| Comparative Example 4 | HEC | 25 | 0.003 | PEO-PPO-PEO | 0.0001 | 10 | 110 |
| Comparative Example 5 | HEC | 120 | 0.003 | PEO-PPO-PEO | 0.00001 | 90 | 95 |

As shown in Table 1, it was confirmed that with the intermediate polishing compositions of Examples 1 to 5 including a surface protective agent $S_1$, which included a water-soluble polymer $P_1$ having a weight-average molecular weight $Mw_{P_1}$ higher than $30 \times 10^4$, further included a dispersant $D_1$ and had an $\alpha_1$ of less than 80%, the number of LPD after final polishing was significantly reduced as compared with the case of Comparative Example 1. Meanwhile, in Comparative Example 4 in which the water-soluble polymer $P_1$ having a weight-average molecular weight $Mw_{P_1}$ of $30 \times 10^4$ or less was used as the intermediate polishing composition, the number of LPD was increased as compared with Comparative Example 1. In addition, in Comparative Example 5 in which $\alpha_1$ was greater than 80% and Comparative Examples 2 and 3 in which the dispersant $D_1$ was not used, the effect of reducing the number of LPD was small.

Although specific examples of the present invention have been described in detail above, they are merely examples and do not limit the scope of the claims. The techniques described in the claims include those in which the specific examples exemplified above are variously modified and changed.

**Claims**

1. An intermediate polishing composition to be used in an intermediate polishing step in a silicon substrate polishing process including both of the intermediate polishing step and a final polishing step, the intermediate polishing composition comprising:

    an abrasive $A_1$, a basic compound $B_1$, and a surface protective agent $S_1$, wherein
    the surface protective agent $S_1$ includes a water-soluble polymer $P_1$ having a weight average molecular weight of higher than $30 \times 10^4$ and a dispersant $D_1$, and
    a dispersibility parameter $\alpha_1$ of the surface protective agent $S_1$ is less than 80%.

2. The intermediate polishing composition according to claim 1, wherein a content of the dispersant $D_1$ is 0.8 times or less a content of the water-soluble polymer $P_1$.

3. The intermediate polishing composition according to claim 1 or 2, wherein a weight average molecular weight of the dispersant $D_1$ is $3 \times 10^4$ or less.

4. The intermediate polishing composition according to any one of claims 1 to 3, wherein the surface protective agent $S_1$ includes a cellulose derivative as the water-soluble polymer $P_1$.

5. The intermediate polishing composition according to any one of claims 1 to 4, wherein a content of the surface protective agent $S_1$ is 0.005 g or more and 5 g or less per 100 g of the content of the abrasive $A_1$.

6. The intermediate polishing composition according to any one of claims 1 to 5, wherein the abrasive $A_1$ includes silica particles.

7. A polishing composition set to be used for polishing a silicon substrate comprising:

the intermediate polishing composition according to any one of claims 1 to 6; and
a final polishing composition to be used in the final polishing step, wherein
the final polishing composition includes an abrasive $A_2$, a basic compound $B_2$, and a surface protective agent $S_2$;
the surface protective agent $S_2$ includes a water-soluble polymer P2; and
a relationship between the dispersibility parameter $\alpha_1$ of the surface protective agent $S_1$ and a dispersibility parameter $\alpha_2$ of the surface protective agent $S_2$ satisfies a following equation: $(\alpha_1/\alpha_2) \geq 0.5$.

8. The polishing composition set according to claim 7, wherein the dispersibility parameter $\alpha_2$ of the surface protective agent $S_2$ is 1% or more and 30% or less.

## INTERNATIONAL SEARCH REPORT

International application No.

PCT/JP2018/003971

### A. CLASSIFICATION OF SUBJECT MATTER
Int.Cl. H01L21/304(2006.01)i, B24B37/00(2012.01)i, C09K3/14(2006.01)i

According to International Patent Classification (IPC) or to both national classification and IPC

### B. FIELDS SEARCHED

Minimum documentation searched (classification system followed by classification symbols)
Int.Cl. H01L21/304, B24B37/00, C09K3/14

Documentation searched other than minimum documentation to the extent that such documents are included in the fields searched
| | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2005-518668 A (ROHM AND HAAS ELECTRONIC MATERIALS CMP HOLDINGS, INC.) 23 June 2005, paragraphs [0005], [0017]-[0033] <br> & US 2003/0154659 A1, paragraphs [0005], [0020]-[0038] & WO 2003/072669 A2 & EP 1478492 A2 & TW 200303343 A & CN 1635940 A & KR 10-2004-0103946 A & AU 2003215261 A | 1-8 |

☒ Further documents are listed in the continuation of Box C.  ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 15.03.2018 | 27.03.2018 |

| Name and mailing address of the ISA/ | Authorized officer |
|---|---|
| Japan Patent Office <br> 3-4-3, Kasumigaseki, Chiyoda-ku, <br> Tokyo 100-8915, Japan | Telephone No. |

Form PCT/ISA/210 (second sheet) (January 2015)

**INTERNATIONAL SEARCH REPORT**

| International application No. |
| --- |
| PCT/JP2018/003971 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | WO 2015/194136 A1 (FUJIMI INCORPORATED) 23 December 2015, paragraph [0016]<br>& JP 2016-4953 A & EP 3159915 A1, paragraph [0022] & CN 106463386 A & KR 10-2017-0015879 A & TW 201608630 A | 1-8 |
| A | WO 2008/044477 A1 (JSR CORPORATION) 17 April 2008, paragraphs [0123], [0124]<br>& US 2009/0221213 A1, tables 1, 2 & EP 2071615 A1 & KR 10-2009-0059109 A & CN 101490814 A & TW 200833825 A | 1-8 |
| A | JP 2016-39179 A (SHIN ETSU CHEMICAL CO., LTD.) 22 March 2016, paragraphs [0023]-[0028]<br>& US 2017/0213742 A1, paragraphs [0032]-[0037] & WO 2016/021117 A1 & DE 112015003214 T5 & TW 201617170 A & KR 10-2017-0041201 A & CN 106663621 A | 1-8 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017029153 A
- JP 2012089862 A
- JP 2015124231 A
- JP 2016004953 A